(19) Europäisches Patentamt
European Patent Office
Office européen des brevets

(11) **EP 3 695 194 B1**

(12) **EUROPÄISCHE PATENTSCHRIFT**

(45) Veröffentlichungstag und Bekanntmachung des Hinweises auf die Patenterteilung:
**11.05.2022 Patentblatt 2022/19**

(21) Anmeldenummer: **18792358.6**

(22) Anmeldetag: **09.10.2018**

(51) Internationale Patentklassifikation (IPC):
*G01D 5/14* (2006.01)    *G01D 5/20* (2006.01)
*G01D 5/245* (2006.01)    *G01R 33/00* (2006.01)
*G01R 33/06* (2006.01)

(52) Gemeinsame Patentklassifikation (CPC):
**G01D 5/2451; G01D 5/145; G01D 5/2046;
G01R 33/0094; G01R 33/063**

(86) Internationale Anmeldenummer:
**PCT/AT2018/060240**

(87) Internationale Veröffentlichungsnummer:
**WO 2019/071284 (18.04.2019 Gazette 2019/16)**

(54) **ELEKTROMAGNETISCHES MESSSYSTEM FÜR DIE ERFASSUNG VON LÄNGE UND WINKEL BASIEREND AUF DEM MAGNETOIMPEDANZEFFEKT**

ELECTROMAGNETIC MEASURING SYSTEM FOR DETECTING LENGTH AND ANGLE ON THE BASIS OF THE MAGNETOIMPEDANCE EFFECT

SYSTÈME DE MESURE ÉLECTROMAGNÉTIQUE PERMETTANT DE DÉTECTER UNE LONGUEUR OU UN ANGLE, SUR LA BASE DE L'EFFET DE MAGNÉTO-IMPÉDANCE

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **12.10.2017 DE 102017123772
13.09.2018 AT 507832018**

(43) Veröffentlichungstag der Anmeldung:
**19.08.2020 Patentblatt 2020/34**

(73) Patentinhaber:
• **Vasiloiu, Victor
5280 Braunau (AT)**
• **Tutzu, Paul
5280 Braunau (AT)**

(72) Erfinder:
• **Vasiloiu, Victor
5280 Braunau (AT)**
• **Tutzu, Paul
5280 Braunau (AT)**

(74) Vertreter: **Westphal, Mussgnug & Partner, Patentanwälte mbB
Werinherstraße 79
81541 München (DE)**

(56) Entgegenhaltungen:
**EP-A1- 1 164 358        DE-A1- 19 509 342
DE-A1-102012 200 195**

**Beschreibung**

TECHNISCHES GEBIET

Die hier beschriebenen Ausführungsbeispiele betreffen eine neuartige elektromagnetische Messeinrichtung zur Positionserfassung, die auf dem physikalischen Effekt der "Giant Magneto Impedance" - GMI - basieren.

HINTERGRUND

Messeinrichtungen für die Länge- und Winkelerfassung sind bekannt und arbeiten nach unterschiedlichen physikalischen Prinzipien. Aus dem Stand der Technik sind beispielsweise EP 1 164 358 A1 und EP 2378253 A2 bekannt.
. Weiter wird eine vergleichende Gegenüberstellung der Hauptmerkmale dieser Messsysteme gemacht:

Optoelektronische Messsysteme haben eine sehr kleine Messperiode (Periode der Teilung des Encoders) und sind dadurch sehr genau, weisen jedoch eine sehr hohe Empfindlichkeit gegenüber mechanischer Belastung (Schock, Vibrationen) und Verschmutzung auf.
Magnetische Messsysteme haben größere Messperiode, sind robust gegenüber Umwelteinflüsse, haben große Abtastabstände (Luftspalt zwischen Abtastkopf und Maßstab),
weisen aber - aufgrund vergleichsweise großer Interpolationsfehler verursacht durch die geringe Abtastfläche der Magnetsensoren und Einzelperiodenabtastung gepaart mit der Inhomogenität der Magnetstärken von Periode zu Periode und haben einen signifikanten Umkehrfehler (Hysterese, bei Änderung der Bewegungsrichtung entsteht ein Signalsprung) - eine geringere Genauigkeit auf.

Induktive Messsysteme haben ähnlich große Messperiode wie die magnetischen Messsysteme, weisen eine höhere Genauigkeit auf und haben keine Hysterese. Der Abtastabstand ist in Verhältnis zu den magnetischen Messsystemen sehr gering und begrenzt dadurch die jeweilige Anwendung.
Der physikalische Magnetoimpedanzeffekt ist an sich bekannt und findet Anwendungen bei Sensoren unterschiedlicher Art. Der Magnetoimpedanzeffekt bewirkt, dass eine ferromagnetische oder weichmagnetische Folie (Draht), die (der) von einem hochfrequenten Strom durchflossen wird, ihre (seine) Impedanz in Abhängigkeit von einem externen elektromagnetischen Feld ändert. Dieses Verhalten kann mit dem an sich bekannten Skin-Effekt wie folgt erklärt werden:

$$\delta = \frac{1}{\sqrt{\pi f \mu \sigma}}$$

mit:

- "$\delta$" - Skin-Eindringstiefe,
- "$f$" - Arbeitsfrequenz,
- "$\mu$" - magnetische Permeabilität,
- "$\sigma$" - elektrische Leitfähigkeit,

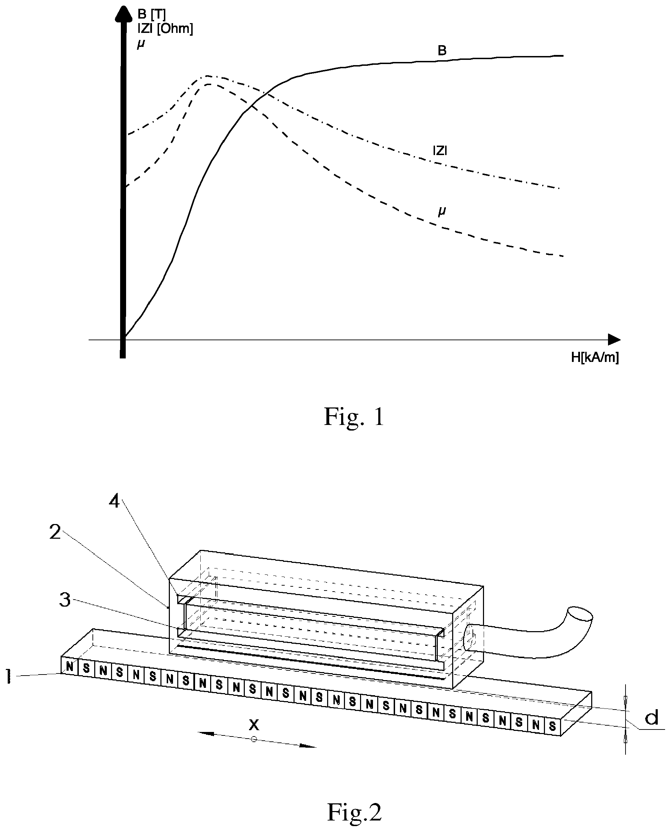

Die Skin-Eindringstiefe $\delta$ der durch das Material fließenden Ströme kann sich für ein bestimmtes Material entweder mit der Frequenz dieser Ströme oder/und mit der magnetischen Permeabilität des Materials ändern. Die Fig. 1 zeigt symbolisch diese Abhängigkeiten, wobei B die magnetische Induktion (Flussdichte), H die magnetische Feldstärke und Z die Impedanz bezeichnet.
Ein äußeres Magnetfeld kann die magnetische Permeabilität einer ferromagnetischen Metallfolie mit einem Faktor $10^N$ (wobei N>2) ändern. Das heißt, dass der Magnetoimpedanzeffekt eine sehr hohe Impedanz-/Reluktanzän-

derung $\left(\frac{\Delta X}{X_0}\right) \times 100\%$ aufweist.
Vergleicht man die Eindringstiefe $\delta$ für ein Material, das in zwei unterschiedlichen Bereichen unter dem Einfluss von zwei elektromagnetischen Feldern der Feldstärke $H_1$ und $H_2$ steht, so erhält man für das Verhältnis $\delta_1/\delta_2$ der jeweiligen Eindringtiefen:

$$\frac{\delta_1}{\delta_2} = \frac{\sqrt{\pi f \mu_2 \sigma}}{\sqrt{\pi f \mu_1 \sigma}} = \sqrt{\frac{\mu_2}{\mu_1}} > 10^{N/2}, \text{ wobei } N > 2.$$

Da die Impedanz Z grundsätzlich umgekehrt proportional zu der Eindringtiefe $\delta$ steht, ergibt sich für das Verhältnis $Z_2/Z_1$ der Impedanzen:

$$Z \sim \frac{1}{\delta} \rightarrow \frac{Z_2}{Z_1} > 10^{N/2}, \text{ wobei } N > 2.$$

Diese hohe Empfindlichkeit zeichnet den Magnetoimpedanzeffekt aus und führt in ihren Anwendungen zu hohen Signalkontrast und weiterführend zu sehr guten Wirkungsgraden.

Im Folgenden werden einige Beispiele von Messgeräten, die sich den GMI-Effekt zunutze machen diskutiert. Aus der Patentschrift US7791331-B2 ist ein Längenmessgerät bekannt das zwei Mäander förmige Windungen aus einer ferromagnetischen Legierung und einem beweglichen einzelnen Magnet aufweist. Durch die dreieckförmige Geometrie diesen Windungen die von einem hochfrequenten Strom durchflossen sind, entsteht eine Variation Ihrer Impedanz abhängig von der relativen Lage des Magnetes. Diese Einrichtung ist begrenzt in ihrem Messbereich gegenüber der Positionsauflösung und Genauigkeit die erreicht werden kann.

Aus der Patentschrift DE19953190-C2 ist ein Winkelencoder bekannt. Es besteht aus einem Sternförmigen Leiter mit planarer Geometrie erzeugt aus einer ferromagnetischen Legierung und aus einem permanent Magnet der sich relativ zu diesem Leiter um ihre Achse drehen kann. Diese Encoderart kann nicht die Rotationsrichtung erfassen (nur die Drehgeschwindigkeit) und hat eine sehr geringe Anzahl von Impulsen pro Umdrehung (Auflösung).

Ein manuell zu handeln Lesekopf basierend auf dem GMI-Effekt für das Ablesen von magnetisch kodierten Bänder ist in der Patentschrift AT406715-B bekannt. Dieses Gerät kann nur das magnetische Pattern aus dem Band ablesen und ist nicht ausgelegt für die Längenbestimmung.

Das induktive Längen- und Winkelmesssystem beschrieben in der Patentschrift EP1164358-B1, bekannt am Markt unter den Namen AMOSIN® erreicht höhere Genauigkeiten und Auflösung in unter Mikrometer Bereich und weist auch keine Hysterese auf. Es hat aber den Nachteil, dass der Abtastabstand zwischen Maßstab und Abtastkopf in etwa zweimal geringer ist als für die hier vorgestellte Messeinrichtung bei gleicher Länge der Teilungsperiode. Darüber hinaus ist der Sensor der hier in der neu vorgestellten Messeinrichtung sehr einfach aufgebaut, hat eine wesentlich höhere Empfindlichkeit und weist höhere Signalamplituden auf.

Die Erfinder haben es sich zur Aufgabe gemacht, eine Messeinrichtung für Längen oder Winkel bereitzustellen, welche sich den Magnetoimpedanzeffekt zu Nutze macht und eine hohe Genauigkeit sowie verhältnismäßig große Abtastabstände ermöglicht, ohne von dem unerwünschten Phänomen der Hysterese betroffen zu sein. Des Weiteren sind geringe Herstellkosten der Sensorik wünschensweist sowie ein flexibler Sensorträger. Weiter wünschenswert ist eine große Abtastfläche über mehrere Perioden des magnetischen Maßstabes hinweg, um dadurch eine gute Signalmittelung und hohe Lagegenauigkeit zu erreichen.

ZUSAMMENFASSUNG

Die erwähnte Aufgabe wird durch eine Messeinrichtung gemäß Anspruch 1 sowie durch ein Verfahren gemäß Anspruch 11 gelöst. Verschiedene Ausführungsbeispiele und Weiterentwicklungen sind Gegenstand der abhängigen Ansprüche.

KURZE BESCHREIBUNG DER ABBILDUNGEN

Verschiedene Ausführungsbeispiele werden nachfolgend anhand von Abbildungen näher erläutert. Die Darstellungen sind nicht zwangsläufig maßstabsgetreu und die Erfindung beschränkt sich nicht nur auf die dargestellten Aspekte. Vielmehr wird Wert daraufgelegt, die zugrundeliegenden Prinzipien darzustellen.:

Figur 1 zeigt ein B/H Diagramm.
Figur 2 illustriert die Hauptkomponenten der hier beschriebenen Ausführungsbeispiele.
Figur 3 illustriert ein erstes Ausführungsbeispiel eines Messsystems zur Messung von Weg oder Winkel.
Figur 4 illustriert ein exemplarisches Beispiel einer elektronischen Schaltung für die Signalauswertung.
Figur 5 illustriert ein zweites Ausführungsbeispiel eines Messsystems zur Messung von Weg oder Winkel.
Figur 6 illustriert ein drittes Ausführungsbeispiel eines Messsystems zur Messung von Weg oder Winkel.
Figur 7 illustriert ein viertes Ausführungsbeispiel eines Messsystems, das für die Winkelmessung geeignet ist.

Figur 8 illustriert ein Beispiel eines magnetischen Maßstabs für ein Messsystem zur Messung der Absolutposition.

DETAILIERTE BESCHREIBUNG

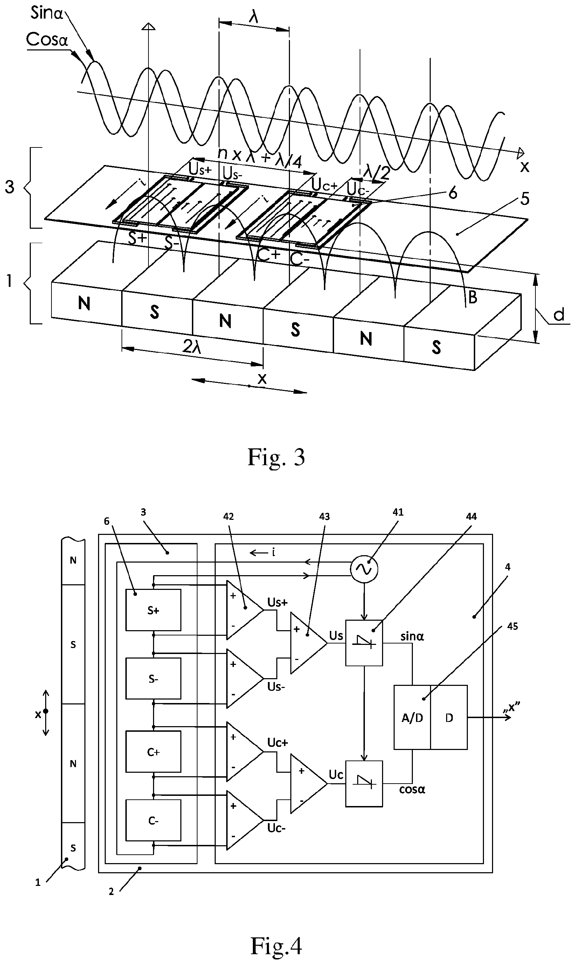

Die hier beschriebenen Ausführungsbeispiele (siehe Fig. 2) umfassen einen magnetischen Maßstab 1 mit hartmagnetischer Teilung mit alternierenden Nord- und Süd-Polen mit gleichen oder unterschiedlichen Pollängen sowie einem Abtastkopf 2, der eine planare Sensoreinheit 3 sowie eine Auswertelektronik 4 aufweist. Die Sensoreinheit 3 beinhaltet eine ferromagnetische Folie 6 (vgl. Fig. 3, Fig. 5 und Fig.6).

Diese zwei Hauptkomponenten der Messeinrichtung (Maßstab 1 und Abtastkopf 2) sind mit einem Luftspalt "d" zueinander angeordnet und mechanisch mit zwei Maschinenelementen gekoppelt, die sich relativ zueinander linear oder rotatorisch bewegen können und deren Relativ- oder Absolutposition (lineare Position bzw. Winkelposition) erfasst wird.

Die Teilung des Maßstabes bewirkt durch die von ihm erzeugten Magnetfelder in der im Abtastkopf 2 angeordneten ferromagnetischen Folie die Entstehung korrespondierender Bereiche höherer und niedrigerer Permeabilität und folglich auch höherer bzw. niedrigerer Impedanz. Diese positionsabhängige Impedanzvariation wird mittels eines oder mehrerer Sensorelemente erfasst und nach der elektronischen Verarbeitung der von den Sensorelementen generierten Sensorsignale in der Auswertelektronik als Positionsinformation ausgegeben. Im Vergleich zu anderen Sensoren (AMR, GMR, etc.) können die hier beschriebenen Messanordnungen gültige Positionsinformationen liefern auch wenn die ferromagnetische Folie, oder lokale Bereiche von ihr, magnetisch gesättigt sind. Das heißt, die Funktionsfähigkeit der ferromagnetischen Folie bleibt erhalten, unabhängig davon, ob die Folie in einem magnetisch linearen, im magnetisch nichtlinearen Bereich oder bei magnetischer Sättigung betrieben wird.

Fig. 2 illustriert ein Ausführungsbeispiel eines Messsystems, welches dazu geeignet ist, unter Verwendung des GMI-Effekts Positionen (Weg oder Winkel) zu messen. Das dargestellte Messsystem umfasst einen als dünnen Streifen realisierten Maßstab 1, der durch das Aufmagnetisieren einer hartmagnetischen Schicht alternierende Polaritäten (Nord N, Süd S) aufweist, die der Einfachheit halber im Folgenden periodisch dargestellt sind (was nicht notwendigerweise der Fall sein muss). Im Wesentlichen ist der Maßstab ein Permanentmagnet mit abwechselnder Polarisierung. Das von dem Permanentmagnet erzeugte Magnetfeld ist positionsabhängig und variiert beispielsweise periodisch mit der Teilung des Maßstabes 1.

Das Messsystem umfasst weiter einen Abtastkopf 2, der einen auf einem dünnen, flexiblen Substrat aufgebauten Magnetimpedanz-Sensor (weiter als Sensoreinheit 3 bezeichnet) sowie eine Auswertelektronik 4 aufweist, welche dazu ausgebildet ist, die Sensorsignale der Sensoreinheit 3 zu verarbeiten und diese in eine relative Positionsinformation des Abtastkopfes (relativ zu dem Maßstab 1 in Messrichtung "x") zu konvertieren. Die Abtastung erfolgt kontaktlos mit einer Distanz "d" (Luftspalt) zwischen Maßstab 1 und Abtastkopf 2.

Die Funktionsweise der Messeinrichtung gemäß dem Beispiel aus Fig. 2 wird anhand des Diagramms in Fig. 3 näher erläutert. Gemäß dem in Fig. 3 dargestellten Ausführungsbeispiel umfasst die Sensoreinheit 3 ein flexibles, nichtmagnetisches Substrat 5, auf dem einzelne dünne Folien 6 (im dargestellten Beispiel vier Stück) aus einem ferromagnetischen Material in einer bestimmten Anordnung und elektrisch von ein andern getrennt aufgebracht sind. Die Folien 6 werden im Folgenden auch als Sensorelemente bezeichnet.

In dem dargestellten Beispiel weisen die ferromagnetischen Folien 6 (Sensorelemente) innerhalb eines Paares von zwei Sensorelementen einen Abstand von etwa $\lambda/2$ auf, wobei $2 \cdot \lambda$ die (magnetische) Teilungsperiode des Maßstabes 1 ist. Die Länge eines Sensorelementes entspricht ungefähr der magnetischen Breite des Maßstabes 1 quer zu Messrichtung. Ein erstes Paar der Folien 6, die mit S+ und S- beschriftet sind, sind einem Sinus-Kanal zugeordnet, wohingegen ein zweites Paar der Folien 6, die mit C+ und C- beschriftet sind, einem Cosinus-Kanal zugeordnet sind. Die beiden Paare von Folien (S+, S- und C+, C-) sind in einem Abstand von etwa $n \cdot \lambda + \lambda/4$ auf dem Substrat 5 angeordnet, wobei n eine ganze Zahl ist.

In einer speziellen Ausführung können auch mehrere erste Folienpaare dem Sinus-Kanal und mehrere zweite Folienpaare dem Cosinus-Kanal zugeordnet sein. Zwei dem Sinus-Kanal (oder dem Cosinus-Kanal) zugeordnete Folienpaare sind in einem Abstand von $n \cdot \lambda$ angeordnet, wohingegen zwei Folienpaare wie erwähnt einen Abstand von etwa $n \cdot \lambda + \lambda/4$ aufweisen, wenn sie unterschiedlichen Kanälen zugeordnet sind.

Die Foliendicke der Folien 6 kann im Bereich zwischen ungefähr 5 $\mu$m und 30 $\mu$m liegen, je nachdem wie die das Messsystem ausgelegt wird und abhängig von Materialeigenschaften, Arbeitsfrequenz, Teilungsperiode, etc.

Der Einfachheit halber ist in Fig. 3 nur eine Mindestzahl von Sensorelementen dargestellt. Es kann für die Signalgewinnung und Mittelung der technologisch bedingten (z.B. geometrischen) Fehler im Sensor und im Maßstab von Vorteil sein, dass - wie bereits erwähnt - mehrere Paare von Sensorelementen entlang der Messrichtung "x" in Abstand von $n \cdot \lambda$ zu ein andern wiederholt angeordnet werden, und die Sensorsignale der Sensorelemente 6 für jeden der zwei Messkanäle (Sinus und Cosinus) summiert werden.

Gemäß dem Beispiel in Fig. 4 weist die im Abtastkopf 3 angeordnete Auswerteelektronik 4 einen Signalgenerator 41 auf, der dazu ausgebildet ist, hochfrequente (in Bereich von 1 MHz bis etwa 100 MHz) Trägerströme konstanter Amplitude zu generieren. Jede der vier dargestellten Sensorelemente 6 (beschriftet mit S+, S-, C+, C-) ist elektrisch so mit dem Signalgenerator verbunden, dass sie von dem Trägerstrom i durchflossen werden. In den hier dargestellten Beispielen sind die Sensorelemente 6 in Reihe geschaltet, so dass derselbe Trägerstrom i durch die Sensorelemente 6 fließt.

Die in der Sensoreinheit 2 angeordneten Sensorelemente 6 (Folien) werden von dem von dem Maßstab 1 erzeugten Magnetfeld (magnetische Flussdichte B) durchsetzt. Wie erwähnt variiert das Magnetfeld entsprechend der Teilung des Maßstabs entlang der Messrichtung (x-Richtung), und folglich hängt die lokale magnetische Feldstärke/Flussdichte in den Sensorelementen 6 von der Relativposition zwischen Sensoreinheit 2 und Maßstab 1 ab. Bei einer Verschiebung des Maßstabs relativ zur Sensoreinheit, verschiebt sich das Magnetfeld entsprechend.

Wie bereits erläutert bewirkt der Magnetoimpedanzeffekt (GMI-Effekt), dass - je nach Größe der magnetischen Flussdichte B - die relative Permeabilität sich in jeder der Sensorelemente/Folien 6 ändert und folglich auch die Stromeindringtiefe (Skin-Effekt) der hochfrequenten Erregerströme und damit auch die Impedanz der Sensorelemente/Folien 6. Die Messung der Impedanzen der vier Sensorelemente /Folien 6 unter Verwendung der Auswertelektronik 4 spiegelt die Abhängigkeit dieser Impedanzen von der relativen Lage des Abtastkopfes 2 zum Maßstab 1 wider. Wie erwähnt können die Sensorelemente/Folien 6 mit einem konstanten Strom i gespeist und die resultierenden Spannungen Us+, Us- und Uc+, Uc-(Spannungsabfälle über den Sensorelementen 6) ausgewertet werden.

Um eine hohe Störfestigkeit zu erreichen und um einen unerwünschten Signaloffset und Rauschen zu unterdrücken, kann die Erfassung der Signale (z.B. Spannungen Us+, Us- und Uc+, Uc-) der Sensorelemente 6 in einer differentiellen Weise erfolgen, sodass ein Sinussignal (Us) durch die Bildung der Spannungsdifferenz Us+ - Us- und ein Cosinussignal (Uc) durch die Bildung der Spannungsdifferenz Uc+ - Uc- ermittelt wird (z.B. mittels Differenzverstärker 42 und 43). Die Differenzsignale Us und Uc (Sinus- und Cosinussignal) weisen dieselbe Frequenz auf wie der hochfrequente Trägerstrom i. Die Signale Us und Uc werden in dem Beispiel aus Fig. 4 demoduliert (Demodulator 44). Das Ergebnis der Demodulation ist eine Gleichspannung deren Pegel bei gleichförmiger Bewegung des Maßstabes 1 relativ zum Abtastkopf 2 annähernd sinus- bzw. cosinusförmig variiert. Im Hinblick auf eine einfache Darstellung werden in den in Fig. 3 und 4 dargestellten Beispielen und in den folgenden Beispielen die zwei um etwa 90° in Phase verschobenen Signale sin $\alpha$ und cosa nach der Demodulation 44 der hochfrequenten Trägerwelle repräsentiert.

Die Auslegung eines elektronischen Schaltkreises, der die Sensorsignale verstärkt, wandelt und in den bekannten normierten Schnittstellen am Ausgang des Abtastkopfs 2 der nachgeschalteten Elektronik für Positionsanzeigen oder Antriebsregelung zu Verfügung stellt, ist an sich bekannt und wird daher nicht weiter erläutert; von Bedeutung ist aber die Tatsache, dass durch die Erzeugung zwei phasenverschobenen sinusförmigen Signale die eindeutige Bewegungsrichtung und den elektrischen Winkel innerhalb einer Periode eindeutig bestimmt werden kann.

Wie bereits erwähnt können sich die vier ferromagnetischen Folien (Sensorelemente 6) in den Sensoreinheit 3 relativ zu dem magnetischen Maßstab 1 bewegen. Diese Sensorelemente 6 werden von einem in Frequenz und Amplitude konstanten Strom (Trägerstrom i) durchflossen, der von der in der Auswertelektronik 4 befindlichen Stromquelle 41 erzeugt wird. Der Spannungsabfall (siehe Fig. 4, Spannungen Us+, Us- und Uc+, Uc-) über jedem den vier Sensorelemente 6 kann als Maß für die Impedanz der jeweiligen Folie betrachtet werden. Diese Spannungen Us+, Usund Uc+, Uc- werden von den Differenzverstärkern 42 bereitgestellt mit den Parametern:

- $I_0$ - konstante Stromamplitude,
- $i$ - Trägerstrom,
- $\omega = 2\pi f$, f- konstante Frequenz,
- $x$ - relative Lage Maßstab 1 zur Sensoreinheit 3,
- $\lambda$ - Hälfte der magnetischenTeilungsperiode,
- $k$ - natürliche Zahl,
- $U_{S+}, U_{S-}, U_{C+}, U_{C-}$ - Teilspannungen,
- $U_k$ - konstante Übertragungsspannung,
- $U_{OS}, U_{OC}$ - konstante Offsetspannungen,
- $\alpha = \frac{2\pi}{\lambda} x$ - elektrischer Winkel,

und $i = I_0 \sin\omega t$
ergibt sich:

$$U_{S+} = U_k \left( U_{OS} + \sin\left(\frac{2\pi}{\lambda} x + 2k\pi\right)\right) \sin\omega t,$$

und

$$U_{S-} = U_k \left( U_{OS} + sin \left( \frac{2\pi}{\lambda} x + \pi + 2k\pi \right) \right) sin\omega t,$$

und in ähnlicher Weise:

$$U_{C+} = U_k \left( U_{OC} + sin \left( \frac{2\pi}{\lambda} x + \frac{\pi}{4} + 2k\pi \right) \right) sin\omega t,$$

und

$$U_{C-} = U_k \left( U_{OC} + sin \left( \frac{2\pi}{\lambda} x + \frac{\pi}{4} + \pi + 2k\pi \right) \right) sin\omega t,$$

und nach der Differenzbildung (Operationsverstärker 43) für jeden der zwei Messkanäle (Sinus- und Cosinuskanal):

$$U_S = U_{S+} - U_{S-} = U_k \, sin\alpha \, sin\omega t$$

$$U_C = U_{C+} - U_{C-} = U_k \, cos\alpha \, sin\omega t$$

Mit Hilfe dieser zweier "Quadratur"-Spannungen kann in bekannter Weise der elektrische Winkel und die Bewegungsrichtung mit Hilfe der Demodulatoren 44, des Analog-Digital Wandlers 45 und weitere digitale Verarbeitung ermittelt und als Positionsinformation "x" ausgeben werde.

Es sei hier festgehalten, dass im Unterschied zu induktiven Messsystemen und aufgrund der Tatsache, dass die Impedanzänderungen nur von dem Betrag der Flussdichte B, jedoch nicht von deren Richtungsvektor abhängig sind, die Sensorsignalperiode λ die Hälfte der Teilungsperiode (2λ) des Maßstabs beträgt. Das kann von großem Vorteil in der Auslegung eines Messsystems sein und erlaub höhere Genauigkeit und Auflösung.

Des Weiteren sei angemerkt, dass der hohe Wirkungsgrad des Magnetoimpedanzeffekts in den hier beschriebenen Ausführungsbeispielen zu höheren Sinus- und Cosinus-Signalamplituden führt und dadurch sich vergleichsweise größere Luftspalte d realisieren lassen, weshalb die hier dargestellten Ausführungsbeispiele vielfältiger anwendbar sind als bekannte Messsysteme.

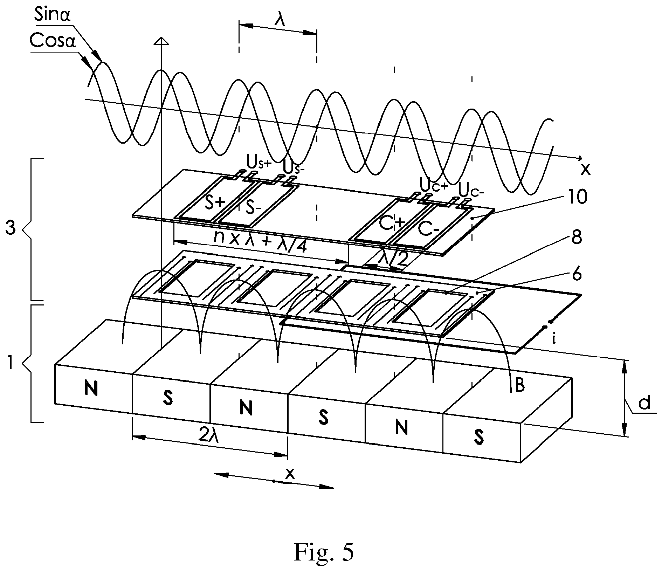

Figur 5 illustriert ein zweites Ausführungsbeispiel der Messeinrichtung, wobei in dem dargestellten Beispiel die Sensoreinheit 3 folgendermaßen realisiert ist: Eine ferromagnetische Folie 6 wird so an die Signalquelle 41 (vgl. Fig. 4) angeschlossen, dass sie in Querrichtung (quer zur Messrichtung x) von dem hochfrequenten Trägerstrom (Erregerstrom) i durchflossen wird (i = $I_0 \cdot$ sin(ωt)). Die Folie 6 weist dabei mindestens zwei Aussparungen 8 mit einer Breite von etwa λ/2 bei einem Abstand von etwa n·λ + λ/4 auf. Die lokale Stromdichte in der Folie 6 hängt von dem beschriebenen Magnetoimpedanzffekt ab. In Abhängigkeit der vom Maßstab 1 erzeugten magnetischen Flussdichte B entstehen in der Folie 6 lokale Bereiche unterschiedlicher Impedanz und demensprechend wird die lokale Stromdichte in der Folie 6 im Wesentlichen die lokale Flussdichte B und damit die Teilung des Maßstabes 1 widerspiegeln. Dieses "Strombild" kann von planaren, parallel zur Folie 6 angeordneten Empfängerspulen 10 differentiell erfasst werden, sodass in ähnlicher Weise wie in dem Ausführungsbeispiel gemäß Fig. 3 und 4 die zwei phasenverschobenen Signale Us und Uc gewonnen werden können.

In diesem Ausführungsbeispiel kann auf die Folienaussparungen 8 möglicherweise auch verzichtet werden, wenn die Systemdimensionierung dies zulässt. Die Empfängerspulen 10 können beispielweise als mehrlagige gedruckte Schaltung (*multilayer printed circuit board*) realisiert werden. In allgemein bekannter Weise lassen sich Magnetfelder die von den Empfängerspulen 10 erfasst werden auch von anderen Art von Sensoren wie Halbleiter-Sensoren wie zum Beispiel Hallsensoren oder magnetischen Dünnfilm-Sensoren wie zum Beispiel Magnetwiderstände (MR), Riesenmagnetwiderstände (GMR) oder anisotrope Magnetwiderstände (AMR) erfassen.

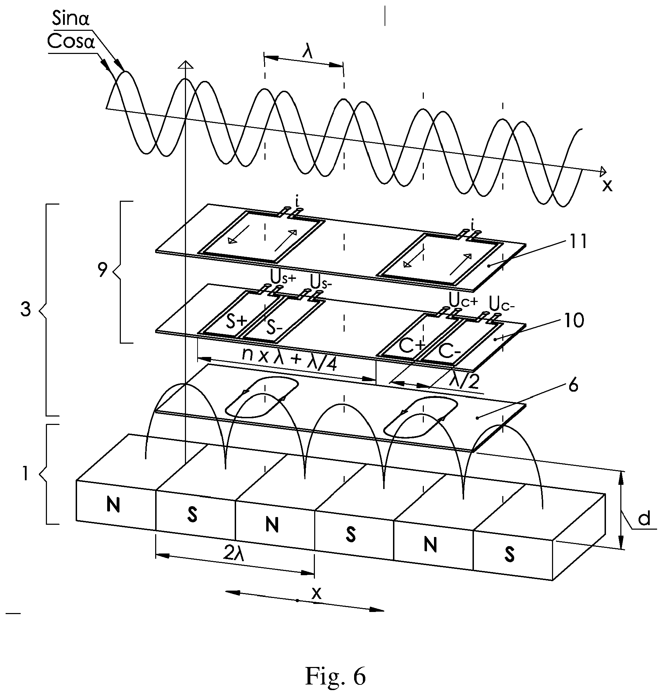

Figur 6 illustriert ein drittes Ausführungsbeispiel der Messeinrichtung. In diesem Fall wird der hochfrequente Trägerstrom i nicht mehr wie in den vorhergehenden Beispielen direkt in die ferromagnetische Folie 6 eingespeist, sondern in Emitterspulen 11, die zusammen mit den Empfängerspulen 10 eine planare Spulenstruktur 9 bilden.

Die Emitterspulen 11 induzieren in bekannter Weise Wirbelströme in der ferromagnetischen Folie 6. Die Stärke und die räumliche Lage (entlang der Messrichtung "x") dieser Wirbelströme hängt von der variablen Magnetoimpedanz in bestimmten Bereichen der Folie 6 ab und ist umgekehrt proportional zu der lokalen magnetischen Flussdichte B des von dem Maßstab 1 erzeugten Magnetfeldes. Die Empfängerspulen 10 haben im Wesentlichen die gleiche Funktion wie in dem vorherigen Beispiel aus Fig. 5 und erfassen in differentieller Weise die lokal variablen Wirbelströmen in den unmittelbar gegenüberliegenden Bereichen der Folie 6. Dieses Ausführungsbeispiel bietet den Vorteil, dass die ferromagnetische Folie als passives Element realisiert werden kann und das Spulensystem als flexible mehrlagige gedruckte Schaltung implementiert und somit leicht an die Auswertungselektronik angeschlossen werden kann.

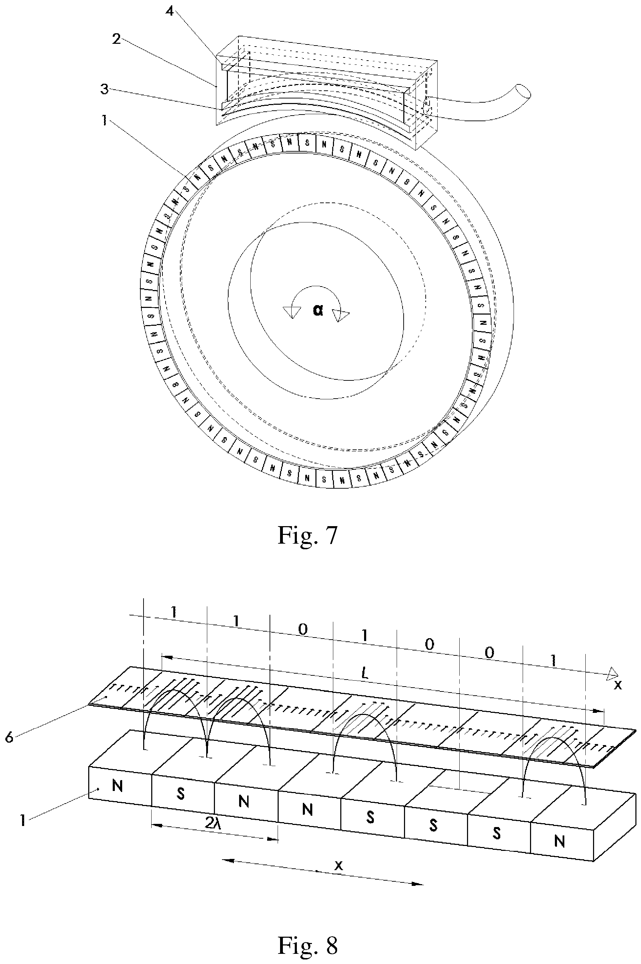

Wie bereits angegeben, ist es vorteilhaft für die Positionsmesseinrichtung, dass die Sensorfläche mehrere Perioden des Maßstabs erfasst. Durch die hier beschriebenen Ausführungsbeispiele einer solchen Messeinrichtung mit flexiblen folienartigen Sensoreinheiten 3 lässt sich bei gleichbleibendem Luftspalt d auch eine Messeinrichtung zur Winkelmessung realisieren. Eine exemplarische Implementierung ist in Fig. 7 dargestellt. Die Funktionsweise ist im Wesentlicheren gleich wie bei den bereits beschriebenen linearen Messanordnungen, wobei der Maßstab 1 als Messtrommel (Encoder-Rad, Multipolrad) ausgebildet ist und relativ zu der Abtastkopf 2 rotieren kann.

Die Oberfläche des Abtastkopfes 2 bzw. der Sensoreinheit 3 lässt sich beliebig an jedem Außendurchmesser Encoder-Rades anpassen. Bei anderen Messeinrichtungen, welche ebene, starre Sensorelemente aufweisen, ist dies nicht ohne weiteres möglich.

Im Allgemeinen können die Länge- und Winkelmesssysteme nach ihrer Arbeitsweise als inkrementelle und absolute Messsysteme klassifiziert werden. Dabei weisen inkrementelle Messeinrichtungen einen lediglich periodisch strukturierten Maßstab 1 auf, und die Positionsinformation kann als Auf- oder Abwärtszählung von Messimpulsen nach einem elektrischen "Reset" ausgegeben. Im Gegensatz dazu steht bei einer absolut messenden Messeinrichtung zu jedem Zeitpunkt der Messung und unabhängig vor dem vorhergehenden Signalverlauf die Absolutposition des Maßstabs 1 relativ zur Abtastkopf 2 zur Verfügung.

Bei inkrementell arbeitenden Messsystemen kann für die Gewinnung eines oder mehrerer "Referenzpulse" eine zusätzliche, zu der periodischen Hauptmessspur parallel verlaufende, zweite Spur auf dem Maßstab 1 vorgesehen sein. In allen beschriebenen Ausführungsbeispielen lässt sich diese "Referenzspur" als beliebige Folge von einzelnen Nord-Süd-Polpaaren umsetzten. Ein in der Sensoreinheit befindlicher Sensor kann in der gleichen Technik realisiert sein wie die Sensorelemente aus den oben beschriebenen Ausführungsbeispielen und kann bei Detektion der Nord-Süd-Polpaare ein entsprechendes Referenzsignal erfassen und ausgeben.

Des Weiteren lässt sich für jedes der hier beschriebenen exemplarischen Messsystemausführungen auch eine die absolute (laterale oder Winkel-) Position erfassende Einrichtung realisieren (siehe Fig. 8).

Für eine Absolutpositionsmessung weist der Maßstab eine Kodierung auf, die eine Absolutposition eindeutig definiert und nach verschiedenen Prinzipien realisiert werden kann. Als Beispiel wurde in Fig. 8 eine sogenannte "Random Code"-Absolutspurausführung dargestellt, wobei der Maßstab 1 eine Reihenfolge von Magnetpolen Nord-Süd mit gleichen oder unterschiedlichen Längen aufweist, sodass im ganzen Messbereich eine bestimmte Kombination (Code) der Länge "L" nur ein einziges Mal vorkommt. Eine solche Absolutspur kann von jeder der hier beschriebenen Ausführungsbeispiele erfasst werden. Eine gleichmäßige angeordnete Sensorfläche besteht aus differentiell arbeitenden einzelnen Sensorelementen und liefert nach der Signalaufbereitung einen bestimmten Code, z.B. "1101001", der die Absolutposition an einer einzigen Stelle definiert.

Für das Erreichen einer höheren Positionsauflösung kann selbstverständlich eine Absolutspur in parallel zu einer hochauflösenden Inkrementalspur auf dem Maßstab aufgebracht werden und in bekannter Weise in Kombination ausgewertet werden.

Sämtliche Beispiele können sowohl in Systemen zur Wegmessung Messung von Verschiebungen oder Position) als auch zur Winkelmessung (bei rotierendem Encoder) eingesetzt werden. Auch ist mit allen Beispielen, je nach Codierung des Maßstabes eine inkrementelle (relative) Messung von (Winkel-) Positionen als auch die Messung einer absoluten (Winkel-) Position möglich.

**Patentansprüche**

1.    Eine Messanordnung zur Weg- oder Winkelmessung mit

einem Maßstab (1) mit entlang einer Messrichtung (x) variierenden Magnetisierung, die ein entsprechend variierendes Magnetfeld (B) bewirkt, und
mindestens einem Abtastkopf (2), der abhängig von der relativen Lage zum Maßstab (1) in Messrichtung (x) von dem variierenden Magnetfeld (B) durchsetzt wird und der folgendes aufweist:

mindestens eine ferromagnetische Folie (6), die aufgrund des Magnetoimpedanz-Effektes eine von dem Magnetfeld (B) anhängige und entlang der Messrichtung (x) variierende lokale elektrische Impedanz aufweist; und

mindestens eine Sensoreinheit (3), die dazu ausgebildet ist, mindestens zwei phasenverschobene Sensorsignale (Us, Uc) zu erzeugen, die von der lokalen elektrischen Impedanz der Folie (6) abhängen.

2. Die Messanordnung gemäß Anspruch 1, die weiter aufweist:

eine Signalquelle, welche dazu ausgebildet ist, einen Wechselstrom (i) mit konstanter Amplitude und konstanter Frequenz bereitzustellen, der in die mindestens zwei entlang der Messrichtung beanstandet angeordneten Folien (6) eingespeist wird,

wobei die Folien (6) selbst als Sensorelemente der Sensoreinheit (3) ausgebildet sind und

wobei das entlang der Messrichtung (x) variierende Magnetfeld (B), welches von der Position des Maßstabs (1) relativ zum Abtastkopf (2) abhängt, die Impedanz der Folien (6) beeinflusst, die als Messinformation (Us+, Us-, Uc+, Uc-) ausgewertet wird.

3. Die Messanordnung gemäß einem der Ansprüche 1 und 2,
wobei die lokalen Stromstärken in der ferromagnetischen Folie (6), die aufgrund des Magnetfeldes (B) lokal variieren, von planaren Spulen (10) erfasst werden.

4. Die Messanordnung gemäß Anspruch 1,

die weiter eine Signalquelle aufweist, welche dazu ausgebildet ist, einen Wechselstrom (i) mit konstanter Amplitude und konstanter Frequenz bereitzustellen,

wobei die Sensoreinheit (3) mindestens eine Emitterspule (11) aufweist, die mit der Signal quelle verbunden und mit der mindestens einer planaren Empfängerspule (10) transformatorisch gekoppelt ist, und

wobei die mindestens eine Folie (6) als Eisenkern fungiert, in der die Emitterspule (11) Wirbelströme induziert, die von der lokalen Impedanz der mindestens einen Folie (6) abhängen.

5. Die Messanordnung gemäß einem der Ansprüche 1 bis 4

wobei die Bildung jeder der Sensorsignale ($U_S$) und $U_C$) durch die Differenzbildung von jeweils zwei Messinformationen (Us+, Us-; Uc+, Uc-) erfolgt;

wobei die zwei Messinformationen (Us+, Us-; Uc+, Uc-) jeweils von mindestens einem Paar einzelner Sensorelemente (S+, S-; C+, C-) generiert werden, die entlang der Messrichtung (x) beabstandet in der Sensoreinheit (3) angeordnet sind.

6. Die Messanordnung gemäß einem der Ansprüche 1 bis 5,

wobei der Maßstab (1) eine regelmäßige Teilung mit einer doppelten Periode ($2 \cdot \lambda$) aufweist, und

wobei die Sensoreinheit (3) mindestens zwei Sensorelemente aus einer ersten Gruppe und mindestens zwei Sensorelemente aus einer zweiten Gruppe umfasst,

wobei die Sensorelemente der ersten Gruppe zueinander einen Abstand aufweisen, der etwa einem ungerade Vielfachen der halben Periode ($(2n+1) \cdot \lambda/2$) entspricht und

wobei die Sensorelemente der zweiten Gruppe relativ zu den Sensorelementen der ersten Gruppe einen Abstand aufweisen der etwa einem Vielfachen der halben Periode plus einem Viertel der Periode ($n \cdot \lambda + \lambda/4$) entspricht.

7. Die Messanordnung gemäß einem der Ansprüche 1 bis 6,
wobei der Maßstab (1) mehrere nebeneinanderliegende magnetische Spuren aufweist.

8. Die Messanordnung gemäß einem der Ansprüche 1 bis 7,
wobei der Maßstab eine Absolutkodierung aufweist, die eindeutig die Lage des Maßstabes relativ zum Abtastkopf (2) definiert.

9. Die Messanordnung gemäß einem der Ansprüche 1 bis 8,
wobei der Maßstab eine Zylinderform aufweist und die Teilung des Maßstabs eine Winkelteilung ist.

10. Die Messanordnung gemäß einem der Ansprüche 1 bis 8,
wobei die Funktionsfähigkeit der ferromagnetischen Folie in linear und nichtlinearen Bereich sowie auch in magnetischer Sättigung gegeben ist.

**11.** Ein Verfahren zur Messung der relativen Lage zwischen einem Maßstab (1) und einem vom Maßstab (1) beabstandeten Abtastkopf (2); das Verfahren umfasst:

Erzeugen eines entlang einer Messrichtung (x) variierenden Magnetfeldes (B) mittels des Maßstabes (1), der eine entlang der Messrichtung variierende Magnetisierung aufweist;

Beeinflussen der lokalen elektrischen Impedanz mindestens einer Folie (6), die in der Sensoreinheit (3) angeordnet ist, wobei die lokale elektrische Impedanz aufgrund des Magnetoimpedanz-Effektes von dem lokalen Magnetfeld und damit von der Lage des Maßstabes (1) relativ zur Sensoreinheit (2) abhängt,

Erzeugen von mindestens zwei phasenverschobenen Sensorsignalen (US, UC) mittels der Sensoreinheit (3), wobei die phasenverschobenen Sensorsignale von der lokalen elektrischen Impedanz der Folie (6) abhängen,

**12.** Das Verfahren gemäß Anspruch 11, das weiter aufweist:

Einspeisen eines hochfrequenten Wechselstromes in die mindestens eine Folie (6), wobei die Stromdistribution entlang der Messrichtung (x) von der lokalen elektrischen Impedanz der mindestens einer Folie (6) abhängt, und Auswertung, insbesondere Demodulieren, des mittels des Sensorelementes erfassten Signals.

**13.** Das Verfahren gemäß Anspruch 12, wobei das Erfassen eines Signals mittels eines Sensorelementes umfasst:

Abgreifen einer Spannung an der mindestens einer Folie (6), wobei die Spannung von der lokalen Impedanz abhängt oder

Erfassen - mittels einer planaren Spule oder eines magnetfeldempfindlichen Halbleiterelementes oder Dünnschichtsensorelements - eines Sensorsignals, das eine magnetische Feldstärke repräsentiert, welche von dem durch die mindestens eine Folie (6) lokal fließenden Wechselstrom bewirkt wird.

**14.** Das Verfahren gemäß Anspruch 13,

wobei die lokale elektrische Impedanz der mindestens einen Folie (6) die den durch mindestens eine Emitterspule (11) induzierten Wirbelströme beeinflusst,

wobei als Sensorelement eine planare Empfängerspule (10) verwendet wird, welche mit der Emitterspule (11) transformatorisch gekoppelt ist und die mindestens eine ferromagnetische Folie (6) als Eisenkern fungiert.

## Claims

**1.** A measuring arrangement for path or angle measurement, having a scale (1) with magnetization that varies along a measuring direction (x), causing a correspondingly varying magnetic field (B), and at least one scanning head (2) which, depending on the relative position with respect to the scale (1) in the measuring direction (x), is penetrated by the varying magnetic field (B), and having:

at least one ferromagnetic film (6) which, due to the magnetoimpedance effect, has a local electrical impedance which is dependent on the magnetic field (B) and varies along the measuring direction (x); and

at least one sensor unit (3) configured to generate at least two phase-shifted sensor signals ($U_S$, $U_C$) which depend on the local electrical impedance of the film (6).

**2.** The measurement arrangement according to claim 1, further having:

a signal source configured to provide an alternating current (i) of constant amplitude and constant frequency, which is fed into the at least two films (6) arranged spaced apart along the measuring direction,

wherein the films (6) themselves are configured as sensor elements of the sensor unit (3), and

wherein the magnetic field (B) varying along the measuring direction (x), which depends on the position of the scale (1) relative to the scanning head (2), influences the impedance of the films (6), which is analysed as measuring information ($U_{S+}$, $U_{S-}$, $U_{C+}$, $U_{C-}$).

**3.** The measuring arrangement according to any one of claims 1 and 2, wherein the local amperages in the ferromagnetic film (6), which vary locally due to the magnetic field (B), are detected by planar coils (10).

4. The measuring arrangement according to claim 1,

   further having a signal source configured to provide an alternating current (i) of constant amplitude and constant frequency,
   wherein the sensor unit (3) has at least one emitter coil (11) which is connected to the signal source and transformer-coupled to the at least one planar receiver coil (10), and
   wherein the at least one film (6) acts as an iron core in which the emitter coil (11) induces eddy currents which depend on the local impedance of the at least one film (6).

5. The measuring arrangement according to any one of claims 1 to 4,

   wherein the formation of each of the sensor signals ($U_S$) and ($U_C$) is effected by forming a difference between two pieces of measuring information ($U_{S+}$, $U_{S-}$; $U_{C+}$, $U_{C-}$);
   wherein each of the two pieces of measuring information ($U_{S+}$, $U_{S-}$; $U_{C+}$, $U_{C-}$) is generated by at least one pair of individual sensor elements (S+, S-; C+, C-), which are arranged in the sensor unit (3) spaced apart along the measuring direction (x).

6. The measuring arrangement according to any one of claims 1 to 5,

   wherein the scale (1) has a regular division with a double period ($2 \cdot \lambda$), and
   wherein the sensor unit (3) comprises at least two sensor elements from a first group and at least two sensor elements from a second group,
   wherein the sensor elements of the first group have a spacing from each other which corresponds to about an odd multiple of half the period ($(2n+1) \cdot \lambda/2$), and
   wherein the sensor elements of the second group have a spacing relative to the sensor elements of the first group which corresponds to about a multiple of half the period plus a quarter of the period ($\eta \cdot \lambda + \lambda/4$).

7. The measuring arrangement according to any one of claims 1 to 6,
   wherein the scale (1) has several adjacent magnetic tracks.

8. The measuring arrangement according to any one of claims 1 to 7,
   wherein the scale has an absolute coding which clearly defines the position of the scale relative to the scanning head (2).

9. The measuring arrangement according to any one of claims 1 to 8,
   wherein the scale has a cylindrical shape, and the division of the scale is an angular division.

10. The measuring arrangement according to any one of claims 1 to 8,
    wherein the functionality of the ferromagnetic film is given in the linear and non-linear range as well as under magnetic saturation.

11. A method for measuring the relative position between a scale (1) and a scanning head (2) spaced apart from the scale (1); the method comprising:

    generating a magnetic field (B) varying along a measuring direction (x) by means of the scale (1), having magnetization that varies along the measuring direction;
    influencing the local electrical impedance of at least one film (6) arranged in the sensor unit (3), wherein, due to the magnetoimpedance effect, the local electrical impedance depends on the local magnetic field and thus on the position of the scale (1) relative to the sensor unit (2),
    generating at least two phase-shifted sensor signals (US, UC) by means of the sensor unit (3), wherein the phase-shifted sensor signals depend on the local electrical impedance of the film (6) .

12. The method according to claim 11, further having:

    feeding a high-frequency alternating current into the at least one film (6), wherein the current distribution along the measuring direction (x) depends on the local electrical impedance of the at least one film (6), and
    analysing, in particular demodulating, the signal detected by the sensor element.

**13.** The method according to claim 12, wherein the detecting of a signal by a sensor element comprises:

tapping a voltage across the at least one film (6), wherein the voltage depends on the local impedance, or detecting - by means of a planar coil or a magnetic fieldsensitive semiconductor element or thin-film sensor element - of a sensor signal which represents a magnetic field strength caused by the alternating current flowing locally through the at least one film (6).

**14.** The method according to claim 13,

wherein the local electrical impedance of the at least one film (6) influences the eddy currents induced by at least one emitter coil (11),
wherein a planar receiver coil (10) is used as the sensor element, which is transformer-coupled to the emitter coil (11), and the at least one ferromagnetic film (6) acts as an iron core.

**Revendications**

**1.** Dispositif de mesure pour la mesure de trajectoire ou d'angle avec

une échelle (1) avec une magnétisation variant le long d'une direction de mesure (x), provoquant un champ magnétique (B) variant en conséquence, et
au moins une tête de balayage (2) qui, en fonction de la position par rapport à l'échelle (1) dans la direction de mesure (x), est traversée par le champ magnétique (B) variable, et présente les caractéristiques suivantes :

au moins une feuille ferromagnétique (6) qui, du fait de l'effet de magnéto-impédance, présente une impédance électrique locale qui dépend du champ magnétique (B) et varie selon la direction de mesure (x) ; et
au moins une unité de capteur (3) qui est conçue pour générer au moins deux signaux de capteur déphasés ($U_S$, $U_C$) qui dépendent de l'impédance électrique locale de la feuille (6).

**2.** Dispositif de mesure selon la revendication 1, comprenant en outre :

une source de signal conçue pour fournir un courant alternatif (i) d'amplitude constante et de fréquence constante qui est introduit dans les au moins deux feuilles (6) disposées à distance le long de la direction de mesure,
dans lequel les feuilles (6) elles-mêmes sont conçues comme des éléments de capteur de l'unité de capteur (3) et
dans lequel le champ magnétique (B) variant le long de la direction de mesure (x), qui dépend de la position de l'échelle (1) par rapport à la tête de balayage (2), influence l'impédance des feuilles (6), qui est évaluée en tant qu'information de mesure ($U_{S+}$, $U_{S-}$, $U_{C+}$, $U_{C-}$).

**3.** Dispositif de mesure selon l'une des revendications 1 et 2, dans lequel les intensités de courant locales dans la feuille ferromagnétique (6), qui varient localement en raison du champ magnétique (B), sont détectées par des bobines planes (10).

**4.** Dispositif de mesure selon la revendication 1,

qui présente en outre une source de signal conçue pour fournir un courant alternatif (i) d'amplitude constante et de fréquence constante,
dans lequel l'unité de capteur (3) présente au moins une bobine émettrice (11) qui est connectée à la source de signal et couplée par transformateur à l'au moins une bobine réceptrice plane (10), et
dans lequel l'au moins une feuille (6) agit comme un noyau de fer, feuille dans laquelle la bobine émettrice (11) induit des courants de Foucault qui dépendent de l'impédance locale de l'au moins une feuille (6).

**5.** Dispositif de mesure selon l'une des revendications 1 à 4,

dans lequel la formation de chacun des signaux de capteur ($U_S$) et $U_C$ a lieu par la formation de différence entre deux informations de mesure respectives ($U_{S+}$, $U_{S-}$ ; $U_{C+}$, $U_{C-}$);
dans lequel les deux informations de mesure ($U_{S+}$, $U_{S-}$ ; $U_{C+}$, $U_{C-}$) sont chacune générées d'au moins une paire d'éléments de capteur individuels (S+, S- ; C+, C-) disposés dans l'unité de capteur (3) à distance le long de la direction de mesure (x).

**6.** Dispositif de mesure selon l'une des revendications 1 à 5,

dans lequel l'échelle (1) présente une division régulière avec une période double (2·λ), et
dans lequel l'unité de capteur (3) comprend au moins deux éléments de capteur d'un premier groupe et au moins deux éléments de capteur d'un second groupe,
dans lequel les éléments de capteur du premier groupe présentent un écart entre eux correspondant environ à un multiple impair de la moitié de la période ((2n+1)·λ/2) et
dans lequel les éléments de capteur du second groupe présentent une distance par rapport aux éléments de capteur du premier groupe, qui correspond approximativement à un multiple de la moitié de la période plus un quart de la période (n·λ+λ/4).

**7.** Dispositif de mesure selon l'une des revendications 1 à 6, dans lequel l'échelle (1) présente plusieurs pistes magnétiques adjacentes.

**8.** Dispositif de mesure selon l'une des revendications 1 à 7, dans lequel l'échelle présente un codage absolu qui définit clairement la position de l'échelle par rapport à la tête de balayage (2).

**9.** Dispositif de mesure selon l'une des revendications 1 à 8, dans lequel l'échelle présente une forme cylindrique et la division de l'échelle est une division angulaire.

**10.** Dispositif de mesure selon l'une des revendications 1 à 8, dans lequel le fonctionnement de la feuille ferromagnétique est donné dans le domaine linéaire et non linéaire ainsi qu'en saturation magnétique.

**11.** Procédé de mesure de la position relative entre une échelle (1) et une tête de balayage (2) espacée de l'échelle (1) ; le procédé comprend :

la génération d'un champ magnétique (B) variant le long d'une direction de mesure (x) au moyen de l'échelle (1), qui présente une magnétisation variant le long de la direction de mesure ;
l'influence de l'impédance électrique locale d'au moins une feuille (6) disposée dans l'unité de capteur (3), dans lequel l'impédance électrique locale dépend du champ magnétique local et donc de la position de l'échelle (1) par rapport à l'unité de capteur (2) en raison de l'effet de magnéto-impédance,
la génération d'au moins deux signaux de capteur déphasés (US, UC) au moyen de l'unité de capteur (3), dans lequel les signaux de capteur déphasés dépendent de l'impédance électrique locale de la feuille (6).

**12.** Procédé selon la revendication 11, comprenant en outre :

l'introduction d'un courant alternatif haute fréquence dans l'au moins une feuille (6), dans lequel la répartition de courant le long de la direction de mesure (x) dépend de l'impédance électrique locale de l'au moins une feuille (6), et
l'évaluation, en particulier la démodulation, du signal détecté par l'élément de capteur.

**13.** Procédé selon la revendication 12, dans lequel la détection d'un signal à l'aide d'un élément de capteur comprend :

le prélèvement d'une tension sur l'au moins une feuille (6), dans lequel la tension dépend de l'impédance locale ou la détection, au moyen d'une bobine plane ou d'un élément semiconducteur sensible au champ magnétique ou d'un élément de capteur à couche mince, d'un signal de capteur qui représente une intensité de champ magnétique provoquée par le courant alternatif circulant localement à travers l'au moins une feuille (6) .

**14.** Procédé selon la revendication 13,

dans lequel l'impédance électrique locale de l'au moins une feuille (6) influence les courants de Foucault induits par au moins une bobine émettrice (11),
dans lequel une bobine réceptrice plane (10) est utilisée comme élément capteur, qui est couplée par transformateur à la bobine émettrice (11) et l'au moins une feuille ferromagnétique (6) agit comme un noyau de fer.

Fig. 1

Fig.2

Fig. 3

Fig.4

Fig. 5

Fig. 6

Fig. 7

Fig. 8

## IN DER BESCHREIBUNG AUFGEFÜHRTE DOKUMENTE

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 1164358 A1
- EP 2378253 A2
- US 7791331 B2
- DE 19953190 C2
- AT 406715 B
- EP 1164358 B1